# EUROPÄISCHE PATENTSCHRIFT

(11) **EP 0 990 301 B1**
(45) Veröffentlichungstag und Bekanntmachung des Hinweises auf die Patenterteilung: **10.10.2001**
(21) Anmeldenummer: 98933455.2
(22) Anmeldetag: 05.05.1998
(51) Int. Cl.: H02M 7/00, H02M 1/12

(54) **LEISTUNGSHALBLEITER-ANORDNUNG AUF DCB-SUBSTRAT**
SEMICONDUCTOR ARRANGEMENT ON A DCB SUBSTRATE
ENSEMBLE SEMI-CONDUCTEUR SUR SUBSTRAT DCB

(30) Priorität: 18.06.1997 DE 19725836
(43) Veröffentlichungstag der Anmeldung: 05.04.2000
(73) Patentinhaber: Infineon Technologies AG, 81669 München (DE)
(72) Erfinder: KLOTZ, Frank, D-81735 München (DE); LORENZ, Leo, D-85579 Neubiberg (DE)
(74) Vertreter: Zedlitz, Peter, Dipl.-Inf.
(86) Internationale Anmeldenummer: DE9801252
(87) Internationale Veröffentlichungsnummer: WO9858440

(56) Entgegenhaltungen:
- EP-A- 0 645 815
- US-A- 5 623 399

## Beschreibung

Die Erfindung betrifft eine Leistungshalbleiter-Anordnung auf einem DCB-Substrat, die einen mit einem positiven Potential verbundenen ersten Zwischenkreisanschluß, einen mit einem negativen Potential verbundenen zweiten Zwischenkreisanschluß und mindestens einen Lastanschluß, mindestens zwei Leistungsschalter zum wechselnden Verbinden des Lastanschlusses mit dem ersten bzw. dem zweiten Zwischenkreisanschluß umfaßt. Solche Leistungshalbleiter-Anordnungen dienen als Leistungsteil zur kontaktlosen Energieumformung entsprechend einer Zielfunktion z. B. in Antriebsstromrichtern mit Drehzahlregelung, unterbrechungsfreien Stromversorgungen (USV), in der Galvanik und zum Einsatz in Schweißstromquellen usw.. Dazu wird an den Versorgungsanschlüssen (Zwischenkreisanschlüssen oder ZK- Anschlüssen) der Leistungshalbleiter-Anordnungen entsprechend des gewünschten Leistungsflusses Energie entnommen und der jeweiligen Last zugeführt bzw. von dieser in den Zwischenkreis zurückgespeist. Der Zwischenkreis ist also ein Energiezwischenspeicher, z. B. in Form einer Kondensatorbatterie. Die Erfindung eignet sich besonders für eine solche Anwendung, ist aber nicht auf diese beschränkt.

Im Stand der Technik ist bei der Leistungshalbleiter-Anordnung der eigentliche Halbleiterchip über Lot mit einer ersten Cu- Schicht verbunden, die ihrerseits auf einer Isolations-Keramik angebracht ist. Die Isolations- Keramik ist über eine zweite Cu- Schicht und Lot mit der Bodenplatte des Aufbaus verbunden. Die Bodenplatte dient zur mechanischen Montage der Anordnung auf einem Kühlkörper und liegt als Berührungsschutz meist auf Masse (Schutzerde).

Leistungselektronische Schaltungen dieser Art, die auf der Basis schneller Schaltvorgänge mit dem Prinzip der Energiewandlung durch Schalten arbeiten, verursachen ein hohes Maß an elektromagnetischer Störemission. Die in einigen Normen (z. B. 50081 /1 /2) vorgeschriebenen Grenzwerte der maximalen Störemission werden dabei weit überschritten und erfordern einen hohen Aufwand an Entstörmaßnahmen. Bei der Verwendung der Leistungshalbleiter-Anordnung nach dem Stand der Technik werden daher i. a. aufwendige, externe Schaltungen nötig, die die durch das schnelle Schalten entstandenen Störströme oder Störspannungen herausfiltern.

Aufgabe der vorliegenden Erfindung ist es, eine Leistungshalbleiter-Anordnung auf einem Halbleitersubstrat zu schaffen, bei der die sich über ihre Anschlußleitungen ausbreitenden Störemissionen unmittelbar an der Halbleitervorrichtung eliminiert oder zumindest stark verringert werden.

Diese Aufgabe wird durch eine Leistungshalbleiter-Anordnung mit den Merkmalen nach Anspruch 1 gelöst. Die Unteransprüche beziehen sich auf vorteilhafte Ausführungsformen der erfindungsgemäßen Leistungshalbleiter-Anordnung.

Das der Erfindung zugrundeliegende Prinzip ist es also, die Störungen zu verringern, indem parasitäre Störstrompfade innerhalb der Leistungshalbleiter-Anordnung kurzgeschlossen werden.

In einer bevorzugten Ausführungsform der Leistungshalbleiter-Anordnung wird eine Verbindungsleitung zwischen dem ersten Zwischenkreisanschluß und dem ersten Leistungsschalter und eine Verbindungsleitung zwischen dem zweiten Zwischenkreisanschluß und dem zweiten Leistungsschalter derart geführt, daß die beiden Zwischenkreisanschlüsse kapazitiv miteinander verbunden sind.

Darüber hinaus kann ein nach außen führender Masseanschluß vorgesehen sein, wobei der Lastanschluß über eine Isolationsschicht kapazitiv mit dem Masseanschluß verbunden ist und die Isolationsschicht eine leitfähige Zwischenschicht aufweist, die mit dem ersten oder zweiten Zwischenkreisanschluß verbunden ist. Die Zwischenschicht besteht vorzugsweise aus Cu oder einer Cu- Legierung.

Außerdem kann die erfindungsgemäße Leistungshalbleiter-Anordnung eine Treiberstufe für die Ansteuerung der Leistungsschalter mit zwei Treiberversorgungsanschlüssen aufweisen, wobei die Treiberversorgungsanschlüsse kapazitiv und/oder galvanisch mit wenigstens einer der Zwischenkreisanschlüsse verbunden ist. (Der Ausdruck "galvanische Verbindung" wird im folgenden verstanden als unmittelbar elektrisch verbunden, mit vernachlässigbar kleinem oder endlichem ohmschen Widerstand, im Gegensatz zu einer kapazitiven oder induktiven Verbindung.) Zusätzlich zu einer kapazitiven Kopplung können die Treiberversorgungsanschlüsse der Treiberstufe auch induktiv miteinander gekoppelt sein.

Die Leistungsschalter der Leistungshalbleiter-Anordnung können aktive Leistungsschalter oder passive Leistungsschalter sein. Außerdem können die Leistungsschalter jeweils mehrere Leistungsschaltelemente umfassen, um die insgesamt erreichbare Schaltleistung zu erhöhen. Die einzelnen aktiven Leistungsschaltelemente können zusätzlich zur Schaltstrecke parallel geschaltete Reversdioden umfassen.

Die Erfindung wird zum besseren Verständnis im folgenden unter Angabe von weiteren Merkmalen und Vorteilen anhand von zeichnerisch dargestellten Ausführungsbeispielen näher erläutert.
- Figur 1: zeigt das Ersatzschaltbild einer Ausführungsform der erfindungsgemäßen Halbleiteranordnung mit zwei Leistungsschaltern;
- Figur 2: zeigt schematisch eine Ausführungsform der erfindungsgemäßen Halbleiteranordnung im Querschnitt;
- Figur 3: zeigt den Ersatzschaltkreis der Halbleiteranordnung nach Figur 2;
- Figur 4a: zeigt das Ersatzschaltbild einer erfindungsgemäßen Halbleiteranordnung mit einer Treiberstufe;
- Figur 4b: zeigt das Ersatzschaltbild einer weiteren Ausführungsform der erfindungsgemäßen Halbleiteranordnung mit einer Treiberstufe.

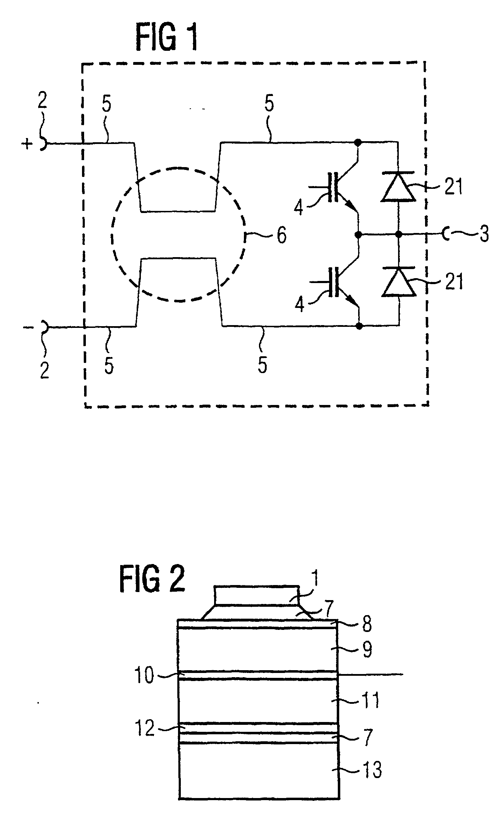

Die Halbleiteranordnung in Fig. 1 ist auf einem DCB-Substrat angeordnet und umfaßt im wesentlichen zwei aktive Leistungsschalter 4 und zwei jeweils parallel geschaltete Reversdioden 21. Diese sind jeweils auf einer Seite über Verbindungsleitungen 5 mit einem Zwischenkreisanschluß 2 verbunden. Auf ihrer anderen Seite sind sie miteinander und außerdem mit einem Lastanschluß 3 verbunden. Bei Ansteuerung über ihren Gate-Anschluß wird nun durch die Leistungsschalter 4 die Verbindung zwischen dem Lastanschluß 3 und einem der Zwischenkreisanschlüsse 2 im wesentlichen kurzgeschlossen und der Lastanschluß 3 so auf ein gewünschtes Potential gelegt.

Bei schneller Änderung des Potentials, auf dem der Lastanschluß 3 liegt, kommt es durch das Schalten zu der Erzeugung von hochfrequenten Störungen. Die sogenannte symmetrische Störung wird über die Zwischenkreisanschlüsse 2 aus der Halbleiteranordnung auf den (nicht dargestellten) Zwischenkreis und darüber hinaus ins Anschlußnetz übertragen und führt dort zu unerwünschten Störeffekten.

Erfindungsgemäß wird zur Unterdrückung der Übertragung dieser symmetrischen Störemission nach außen eine kapazitive Kopplung 6 der beiden Leitungen 5 durch eine spezielle Führung der Verbindungsleitungen 5 in der Halbleiteranordnung und einen niederinduktiven Kondensator herbeigeführt. Durch diese Kapazität werden hochfrequente Ströme, die von den Leistungsschaltern 4 ausgehen, innerhalb der Halbleiteranordnung kurzgeschlossen und gelangen so nicht nach außen.

Darüber hinaus können weitere geeignete Maßnahme bezüglich der Verbindungsleitungen 5 getroffen werden, um die Größe der kapazitiven Kopplung 6 festzulegen.

In einer weiteren Ausführungsform der erfindungsgemäßen Halbleiteranordnung wird ein anderer Störstrompfad intern in der Anordnung geschlossen. Die Ausführungsform ist in Fig. 2 im Querschnitt dargestellt. Das Halbleitersubstrat 1 ist über eine Lotschicht 7 und eine erste Kupferschicht 8 auf einer ersten Isolationsschicht 9 angeordnet. Diese Schichtstruktur ist als DCB (direct copper bonding) allgemein bekannt. Beim (nicht dargestellten) Stand der Technik schließt sich auf der Unterseite der Isolationsschicht eine zweite Kupferschicht 12 an, die wiederum über eine Lotschicht 7 mit einer Bodenplatte 13, die den ganzen Aufbau trägt, verbunden ist. Als Schutzmaßnahme liegt diese Bodenplatte 13 auf Masse. Die Isolationsschicht kann dabei ein Nitrit, BeO, AlNi, Diamant o. ä. sein.

Beim Schalten der Leistungsschalter 4 auf dem Halbleitersubstrat 1 kommt es aber durch das Aufladen und Entladen der durch die Anordnung Halbleitersubstrat 1 - Bodenplatte 13 gebildeten Kapazität zu sogenannten asymmetrischen Störungen. Diese asymmetrischen Störungen entstehen dadurch, daß parasitäre Kapazitäten bei schnellen Spannungsänderungen aufgeladen und entladen werden. Die Störungen breiten sich daher über Anschlußleitungen und über Masseanschlüsse aus.

Erfindungsgemäß wird zur Unterdrückung der Übertragung dieser asymmetrischen Störemission nach außen die Isolationsschicht in eine erste Isolationsschicht 9 und eine zweite Isolationsschicht 11 durch eine dazwischen liegende leitfähige Zwischenschicht 10 unterteilt. Dadurch erhält man einen Zwischenabgriff "in" der Kapazität aus Substrat 1 und Bodenplatte 13. Dieser Zwischenabgriff wird erfindungsgemäß mit einem der Zwischenkreisanschlüsse 2 verbunden. Dadurch werden hochfrequente Ströme, die von den Leistungsschaltern 4 ausgehen und kapazitiv über die Bodenplatt 13 zur Masse abfließen würden, innerhalb der Halbleiteranordnung kurzgeschlossen und gelangen so nicht nach außen. Auf den Masseanschluß werden keine Potentialschwankungen übertragen.

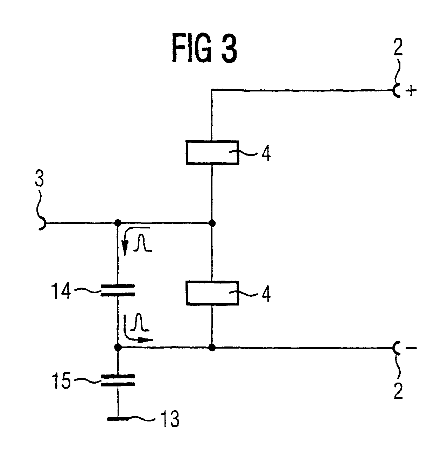

Das elektrische Ersatzschaltbild des Aufbaus in Fig. 2 ist in Fig. 3 gezeigt. Wie in Fig. 1 bereits beschrieben, schalten die beiden Schalter 4 den Lastanschluß 3 mit jeweils einem der Zwischenkreisanschlüsse 2 je nach gewünschtem Potential des Lastanschlusses 3 kurz. Das Halbleitersubstrat 1 und damit der Lastanschluß 3 ist über den oben beschriebenen schichtweisen Aufbau der Halbleiteranordnung kapazitiv mit der Bodenplatte 13 und damit mit der Masse gekoppelt. Diese Kapazität ist in zwei Teilkapazitäten 14 und 15 unterteilt. Nach der ersten Teilkapazität 14 erfolgt ein Abgriff, der auf ein Gleichspannungspotential gelegt wird, in dem hier dargestellten Fall ist der Abgriff mit dem Zwischenkreisanschluß auf dem negativen Potential verbunden. Die zweite Teilkapazität 15 koppelt den Aufbau schließlich kapazitiv an die Masse. Physikalisch sind die Teilkapazitäten 14 und 15 aufgebaut aus der ersten Cu-Schicht 8, der ersten Isolationsschicht 9 und der leitfähigen Zwischenschicht 10 einerseits sowie der Zwischenschicht 10, der zweiten Isolationsschicht 11 und der zweiten Cu-Schicht 12 andererseits.

Der asymmetrische Störstrom, der von den dem Halbleitersubstrat 1 aus erzeugt wird, wird somit quasi vor dem Erreichen der Masse abgeleitet und einem Zwischenkreisanschluß zugeführt, wodurch sich der Störstrompfad innerhalb der Aufbaus schließt.

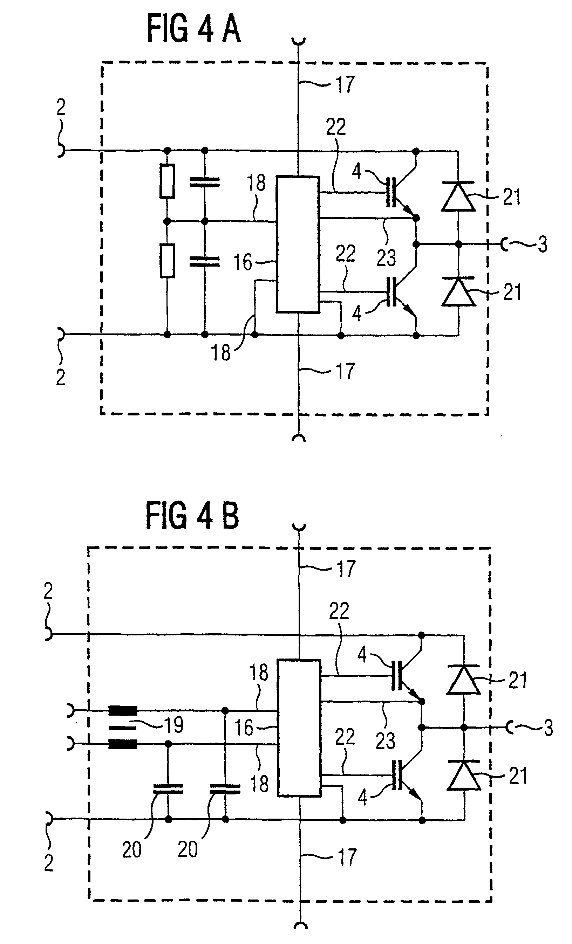

Die asymmetrischen Störungen können sich außer über die Masse und die Versorgungsanschlüsse (zum ZK) auch über weitere Anschlüsse der Halbleiteranordnung ausbreiten. Dies ist insbesondere der Fall, wenn die Schalter 4 über eine gemeinsame oder jeweils eine eigene integrierte Treiberstufe angesteuert werden. Eine derartige Schaltung ist in Fig. 4a und in Fig. 4b dargestellt.

Der Aufbau der Leistungshalbleiter-Anordnung in Fig. 4a und 4b weist neben den aus Fig. 1 bekannten Elementen außerdem eine Treiberstufe 16 auf, die mindestens mit den Gate- und Emitter-/Source- Anschlüssen der Leistungsschalter 4 verbunden ist und zwei Ansteuerungsanschlüsse 17 aufweist. In der Ausführungsform nach Fig. 4a ist die Treiberstufe 16 zur Stromversorgung mit Treiberversorgungsanschlüssen 18 versehen, die mit den Zwischenkreisanschlüssen 2 verbunden sind. Der Abgriff erfolgt bei dieser Ausführungsform über Kapazitäten und Widerstände einerseits und einer direkten Verbindung mit einem Zwischenkreisanschluß 2 andererseits.

In der in Fig. 4b dargestellten Ausführungsform der Halbleiteranordnung erfolgt die Versorgung von außen. In diesem Fall werden die externen Anschlüsse kapazitiv über Filterkapazitäten 20 mit einem Zwischenkreisanschluß 2 verbunden. Hierdurch werden wiederum Strompfade für hochfrequente Störströme modulintern, d. h. innerhalb der erfindungsgemäßen Leistungshalbleiter-Anordnung geschlossen.

Um eine weitere Abschirmung in bezug auf hochfrequente Störungen nach außen zu erzielen, werden in der Ausführungsform nach Fig. 4b die beiden Treiberversorgungsanschlüsse 18 auβerdem induktiv miteinander gekoppelt 19.

Bei beiden Ausführungsformen der Halbleiteranordnung in den Fig. 4a und 4b sind die Treiberstufen 16 frei floatend ausgelegt und erzeugen eine Gate- Source-/Emitter- Spannung zwischen einem Gate-Anschluß 22 und einem Source-/Emitter- Anschluß 23 mit einem Absolutwert von etwa 15V, höchstens 20V, wobei das Potential des Lastanschlusses aber auf z. B. 700V gegenüber Masse liegen kann.

Die Schalter 4 in den oben beschriebenen Ausführungsformen können aktive Schalter, wie z. B. IGBTs, Leistungs-MOS-FETs, bipolare Transistoren, Thyristoren, GTO-Thyristoren etc. oder passive Schalter wie Dioden sein. Dabei können die Leistungsschalter 4 aus mehreren, zwischen dem Zwischenkreisanschluß 2 und dem Lastanschluß 3 seriell oder parallel geschalteten einzelnen Schaltelementen bestehen. Ferner können die aktiven Schaltelemente wie in Fig. 4a und 4b dargestellt Reversdioden 21 aufweisen.

Bei der Dimensionierung der kapazitiven und induktiven Größen in der erfindungsgemäßen Halbleiteranordnung kann auf externe Werte der Last bezug genommen werden, d. h. die Halbleiteranordnung gemäß Erfindung kann für spezielle ohmsche, induktive oder kapazitive Lastwerte ausgelegt werden.

Zur Reduzierung des u. U. angestiegenen Wärmewiderstandes aufgrund der Unterteilung der Isolationsschicht in der Ausführungsform nach Fig. 2 können zusätzliche, Wärme ableitende Elemente an der Halbleiteranordnung vorgesehen werden.

### Bezugszeichenliste:

- 1: Halbleitersubstrat
- 2: Zwischenkreisanschluß
- 3: Lastanschluß
- 4: Leistungsschalter
- 5: Verbindungsleitung
- 6: kapazitive Kopplung
- 7: Lot
- 8: erste Cu-Schicht
- 9: erste Isolationsschicht
- 10: Zwischenschicht
- 11: zweite Isolationsschicht
- 12: zweite Cu-Schicht
- 13: Bodenplatte
- 14: erste Teilkapazität
- 15: zweite Teilkapazität
- 16: Treiberstufe
- 17: Ansteuerungsanschluß
- 18: Treiberversorgungsanschluß
- 19: induktive Kopplung
- 20: Filterkapazitäten
- 21: Reversdioden
- 22: Gate- Anschluß
- 23: Source-/Emitter- Anschluß

## Patentansprüche

1. Leistungshalbleiter-Anordnung auf einem DCB-Substrat, die umfaßt:
- einen mit einem positiven Potential verbundenen ersten Zwischenkreisanschluß (2), einen mit einem negativen Potential verbundenen zweiten Zwischenkreisanschluß (2) und mindestens einen Lastanschluß (3),
- mindestens zwei Leistungsschalter (4) zum wechselnden Verbinden des Lastanschlusses (3) mit dem ersten bzw. dem zweiten Zwischenkreisanschluß (2),
**dadurch gekennzeichnet, daβ**
- Verbindungen, die wenigstens einige der nach außen führenden Anschlüsse (2, 3, 13) der Leistungshalbleiter-Anordnung paarweise kapazitiv miteinander verbinden, wobei ein nach außen führender Masseanschluß (10) vorgesehen ist, der über eine Isolationsschicht (9, 11) kapazitiv mit dem Lastanschluß (3) verbunden ist und wobei die Isolationsschicht (9, 11) eine leitfähige Zwischenschicht aufweist, die mit dem ersten oder zweiten Zwischenkreisanschluß (2) verbunden ist.

2. Leistungshalbleiter-Anordnung nach Anspruch 1,
**dadurch gekennzeichnet,**
**daß** eine Verbindungsleitung (5) zwischen dem ersten Zwischenkreisanschluß (2) und dem ersten Leistungsschalter (4) und eine Verbindungsleitung (5) zwischen dem zweiten Zwischenkreisanschluß (2) und dem zweiten Leistungsschalter (4) derart geführt sind, daß die beiden Zwischenkreisanschlüsse (2) kapazitiv miteinander verbunden (6) sind.

3. Leistungshalbleiter-Anordnung nach Anspruch 1 oder 2,
**dadurch gekennzeichnet,**
**daß** die Zwischenschicht aus Cu oder einer Cu-Legierung besteht.

4. Leistungshalbleiter-Anordnung nach einem der vorangehenden Ansprüche,
**gekennzeichnet durch**
eine Treiberstufe (16) für die Ansteuerung der Leistungsschalter (4) mit zwei Treiberversorgungsanschlüssen (18), wobei die Treiberversorgungsanschlüsse (18) kapazitiv und/oder galvanisch mit wenigstens einer der Zwischenkreisanschlüsse (2) verbunden sind.

5. Leistungshalbleiter-Anordnung nach Anspruch 4,
**dadurch gekennzeichnet,**
**daß** die Treiberversorgungsanschlüsse (18) der Treiberstufe (16) induktiv miteinander gekoppelt sind.

6. Leistungshalbleiter-Anordnung nach einem der vorangehenden Ansprüche,
**dadurch gekennzeichnet,**
**daß** die Leistungsschalter (4) IGBTs umfassen.

7. Leistungshalbleiter-Anordnung nach einem der Ansprüche 1 bis 6,
**dadurch gekennzeichnet,**
**daß** die Leistungsschalter (4) Leistungs-MOSFETs umfassen.

8. Leistungshalbleiter-Anordnung nach Anspruch 6 oder 7,
**dadurch gekennzeichnet,**
**daß** die Leistungsschalter (4) Reversdioden (21) parallel zur Schaltstrecke umfassen.

9. Leistungshalbleiter-Anordnung nach einem der vorangehenden Ansprüche,
**dadurch gekennzeichnet,**
**daß** die Leistungsschalter (4) jeweils mehrere, wirkungsmäßig seriell geschaltete Leistungsschaltelemente umfassen.

10. Leistungshalbleiter-Anordnung nach einem der Ansprüche 1 bis 8,
**dadurch gekennzeichnet,**
**daß** die Leistungsschalter (4) jeweils mehrere, wirkungsmäßig parallel geschaltete Leistungsschaltelemente umfassen.

## Claims

1. Power semiconductor arrangement on a DCB substrate, which comprises:
- a first intermediate circuit terminal (2) connected to a positive potential, a second intermediate circuit terminal (2) connected to a negative potential, and at least one load terminal (3),
- at least two power switches (4) for alternately connecting the load terminal (3) to the first or respectively the second intermediate circuit terminal (2),
**characterized by**
- connections which capacitively connect together in pairs at least some of the outwardly leading terminals (2, 3, 13) of the power semiconductor arrangement, an outwardly leading earth terminal (10) being provided, which is capacitively connected to the load terminal (3) via an insulation layer (9, 11) and the insulation layer (9, 11) having a conductive intermediate layer connected to the first or second intermediate circuit terminal (2).

2. Power semiconductor arrangement according to Claim 1,
**characterized**
**in that** a connecting line (5) between the first intermediate circuit terminal (2) and the first power switch (4) and a connecting line (5) between the second intermediate circuit terminal (2) and the second power switch (4) are routed in such a way that the two intermediate circuit terminals (2) are capacivitely connected (6) to one another.

3. Power semiconductor arrangement according to Claim 1 or 2,
**characterized**
**in that** the intermediate layer is composed of Cu or a Cu alloy.

4. Power semiconductor arrangement according to one of the preceding claims,
**characterized by**
a driver stage (16) for driving the power switches (4) with two driver supply terminals (18), the driver supply terminals (18) being capacitively and/or directly electrically connected to at least one of the intermediate circuit terminals (2).

5. Power semiconductor arrangement according to Claim 4,
**characterized**
**in that** the driver supply terminals (18) of the driver stage (16) are inductively coupled to one another.

6. Power semiconductor arrangement according to one of the preceding claims,
**characterized**
**in that** the power switches (4) comprise IGBTs.

7. Power semiconductor arrangement according to one of Claims 1 to 6,
**characterized**
**in that** the power switches (4) comprise power MOSFETs.

8. Power semiconductor arrangement according to Claim 6 or 7,
**characterized**
**in that** the power switches (4) comprise reverse diodes (21) in parallel with the switching path.

9. Power semiconductor arrangement according to one of the preceding claims,
**characterized**
**in that** the power switches (4) each comprise a plurality of power switching elements effectively connected in series.

10. Power semiconductor arrangement according to one of Claims 1 to 8,
**characterized**
**in that** the power switches (4) each comprise a plurality of power switching elements effectively connected in parallel.

## Revendications

1. Dispositif à composant à semiconducteur de puissance sur un substrat DCB qui comprend :
- une première borne (2) de circuit intermédiaire reliée à un potentiel positif, une deuxième borne (2) de circuit intermédiaire reliée à un potentiel négatif et au moins une borne (3) de charge,
- au moins deux interrupteurs de puissance (4) pour relier, en alternance, la borne (3) de charge à la première et à la deuxième bome (2) de circuit intermédiaire,
**caractérisé en ce qu'**il comprend
- des liaisons qui relient entre elles capacitivement par paire au moins quelques unes des bornes (2, 3, 13), allant vers l'extérieur du dispositif à composant à semiconducteur de puissance, et il est prévu une bome (10) de masse, menant vers l'extérieur et qui est reliée par une couche (9, 11) d'isolement capacitivement à la borne (3) de charge, et la couche (9, 11) d'isolement comporte une couche intermédiaire conductrice qui est reliée à la première ou à la deuxième borne (2) de circuit intermédiaire.

2. Dispositif à composant à semiconducteur de puissance suivant la revendication 1,
**caractérisé**
**en ce qu'**il passe une ligne (5) de liaison, entre la première borne (2) de circuit intermédiaire et le premier interrupteur de puissance (4), et une ligne (5) de liaison entre la deuxième borne (2) de circuit intermédiaire et le deuxième interrupteur de puissance (4), de façon à ce que les deux bornes (2) de circuit intermédiaire soient reliées (6) capacitivement entre elles.

3. Dispositif à composant à semiconducteur de puissance suivant la revendication 1 ou 2, **caractérisé en ce que** la couche intermédiaire est en Cu ou en un alliage de Cu.

4. Dispositif à composant à semiconducteur de puissance suivant l'une des revendications précédentes, **caractérisé par** un étage (16) d'attaque pour la commande de l'interrupteur de puissance (4), ayant deux bornes (18) d'alimentation de circuit d'attaque, les bornes (18) d'alimentation de circuit d'attaque étant reliées capacitivement et/ou galvaniquement à au moins l'une des bornes (2) de circuit intermédiaire.

5. Dispositif à composant à semiconducteur de puissance suivant la revendication 4, **caractérisé en ce que** les bornes (18) d'alimentation de l'étage (16) d'attaque sont couplées inductivement entre elles.

6. Dispositif à composant à semiconducteur de puissance suivant l'une des revendications précédentes, **caractérisé en ce que** les interrupteurs de puissance (4) comprennent des IGBT.

7. Dispositif à composant à semiconducteur de puissance suivant l'une des revendications 1 à 6, **caractérisé en ce que** les interrupteurs de puissance (4) comprennent des MOSFET de puissance.

8. Dispositif à composant à semiconducteur de puissance suivant la revendication 6 ou 7, **caractérisé en ce que** les interrupteurs de puissance (4) comprennent des diodes (21) montées en inverse en parallèle avec la section de commutation.

9. Dispositif à composant à semiconducteur de puissance suivant l'une des revendications précédentes, **caractérisé en ce que** les interrupteurs de puissance (4) comprennent respectivement, plusieurs éléments de circuit de puissance montés en série du point de vue de leur action.

10. Dispositif à composant à semiconducteur de puissance suivant l'une des revendications 1 à 8, **caractérisé en ce que** les interrupteurs de puissance (4) comportent respectivement, plusieurs éléments de circuit de puissance montés en parallèle du point de vue de leur action.
